# NEUE EUROPÄISCHE PATENTSCHRIFT

(11) **EP 0 654 962 B2**
(45) Veröffentlichungstag und Bekanntmachung des Hinweises auf die Entscheidung über den Einspruch: **25.07.2007**
(45) Hinweis auf die Patenterteilung: 04.02.1998
(21) Anmeldenummer: 94250279.0
(22) Anmeldetag: 17.11.1994
(51) Int. Cl.: H05K 9/00

(54) **Abschirmelement und Verfahren zu dessen Herstellung**
Shielding member and manufacturing method of such a member
Membre de blindage et procédé de fabrication d'un tel membre

(30) Priorität: 22.11.1993 DE 4340108
(43) Veröffentlichungstag der Anmeldung: 24.05.1995
(73) Patentinhaber: EMI-tec elektronische Materialien GmbH, 12277 Berlin (DE)
(72) Erfinder: Tiburtius, Bernd, Dipl.-Ing., D-14532 Kleinmachnow (DE); Kahl, Helmut, Dipl.-Ing., D-12307 Berlin (DE)
(74) Vertreter: Glawe, Delfs, Moll

(56) Entgegenhaltungen:
- EP-A- 0 177 067
- EP-A- 0 182 931
- EP-A- 0 200 296
- EP-A- 0 428 335
- EP-A- 0 629 114
- EP-A- 0 643 552
- DE-A- 3 934 845
- DE-C- 3 902 998
- FR-A- 2 270 956
- GB-A- 2 261 324
- JP-A- 5 717 793
- US-A- 3 140 342
- US-A- 4 652 695
- US-A- 4 659 869
- US-A- 4 931 479
- US-A- 5 099 090
- US-A- 5 107 404
- Produktinformation Technical Wire Products Inc. Data Sheet RF-101
- Produktinformation Technical Wire Product Inc. Data Sheet RF-290, 1962
- Produktinformation der Parker Hanifin Corporation 'Parshield Conductive Elastomers" 1990/1991
- Anzeige SRS Industries in ITEM 1986, Seite 330, 1986
- Anzeige der REDEX-DOPAG in L'année Technologique 1989, Seite 435
- Produktinformation der STEATITE INSULATIONS LTD 'CHO-BOND CHO-SHIELD' 1979
- GREG CURTIN: 'Molded-in-place metal/conductive elastomer seals for effective longterm EMI/EMP attenuation' (ITEM 1988)
- Hewlett Packard Journal, S. 14/15, 12/85, 'Internally modular signal generaler, mechanical design'
- Parker Seals "The engineerd" seal canapt, 8/1992

## Beschreibung

Die Erfindung betrifft ein Abschirmelement sowie ein Verfahren zur Herstellung eines solchen Abschirmelements.

Elektronische Bauelemente, aber auch gegenüber elektromagnetischer Strahlung störungsempfindliche Meß-, Untersuchungs- und ähnliche Anordnungen, benötigen zu ihrem störungsfreien Betrieb eine Abschirmung gegenüber den am Betriebsort vorhandenen elektromagnetischen Feldern.

Sie werden daher in abschirmenden Gehäusen untergebracht, die in den Wandungen leitfähiges Material aufweisen und im Sinne eines Faradayschen Käfigs wirken.

Solche Gehäuse finden darüber hinaus Anwendung für Geräte oder Baugruppen, die ihrerseits elektromagnetische Strahlung emittieren, die es von der Umgebung fernzuhalten gilt - sei es, um die Abstrahlung geheimzuhaltender Information oder Funktionsbeeinträchtigungen externer Geräte zu verhindern.

Derartige Schirmungen gegen die Ab- oder Einstrahlung von elektromagnetischen Störungen (electromagnetic interferences = EMI) müssen heute um so wirksamer sein, je mehr elektronische Geräte betrieben werden und je dichter diese Geräte im Betrieb beieinander angeordnet sein müssen. Schließlich erfordert auch der beständige Leistungs- und Empfindlichkeitszuwachs derartiger Geräte eine zusätzliche Verbesserung der Abschirmmaßnahmen. Hinzu kommt, daß hierfür immer weniger Raum zur Verfügung steht, da die betreffenden Geräte auch noch miniaturisiert sein sollen. Die sogenannte "elektromagnetische Verträglichkeit" (EMV) bildet somit heutzutage neben ihren eigentlichen Funktionseigenschaften eine wesentliche qualitätsbestimmende Größe elektronischer Geräte.

Sofern es sich bei den Gehäusen - was in der Praxis meist der Fall ist - um mehrteilige Konstruktionen handelt, bei denen zumindest ein gelegentliches Öffnen (etwa zur Erneuerung der Energiequelle oder zu Wartungszwecken) möglich sein muß, ist es zur Erreichung einer wirkungsvollen Abschirmung erforderlich, die beim Öffnen voneinander zu lösenden und beim Verschließen wieder miteinander in Kontakt zu bringenden Gehäuseteile mit elastischen leitfähigen Dichtungen zu versehen.

Dazu sind zum einen federartige metallische Abdichtungen bekannt, die jedoch konstruktiv vergleichsweise aufwendig sind und deren Funktionsfähigkeit durch Oxidation und Verschmutzung stark beeinträchtigt werden kann.

Weiterhin sind - etwa aus US 46 59 869 oder DE-OS 28 27 676 - flexible Dichtprofile aus leitfähigen oder leitend gemachten Elastomeren bekannt, die zur Erzeugung der Leitfähigkeit mit Kohlenstoff- oder Metallpartikeln versetzt sind.

Derartige Dichtungsprofile werden üblicherweise als separate, insbesondere ringförmig geschlossene, Dichtungsprofile gefertigt - vor allem als Stanzteile - und anschließend im Bereich von Wandungsgrenzen in das abzuschirmende Gehäuse eingelegt oder zwischen leitend abschirmende Flächen, auch von Leiterplatinen - eingefügt, um auf diese Weise einen leitende und dichtende Überbrückung zur Erzeugung eines abgeschlossenen elektromagnetisch abgeschirmten Volumens zu bilden.

Die Stanzschritte zur Herstellung solcher Dichtungsprofile sind abfallintensiv, und ihre Handhabung ist insofern unbequem, als das exakte Einlegen der sehr wenig formstabilen Elemente in entsprechende Nuten o.ä. im Gehäuse Geschick erfordert und sich schwer automatisieren läßt.

Kompliziert geformte Dichtungen, wie sie für spezielle Gehäuse erforderlich sein können, benötigen zum Einlegen spezielle Vorrichtungen, die die Fertigung der Gehäuse insgesamt verteuern. Außerdem ist das präzise Einlegen zeitaufwendig und erfordert zusätzliche Nachkontrollen.

Zudem sind beschädigte, ausgetauschte Dichtungsprofile dieser Art wegen des notwendigerweise hohen Anteils leitfähiger Beimengungen im gesamten Volumen schwer wiederverwertbar.

Es ist auch bekannt, die in Rede stehenden Abschirmprofile heiß in Preßformen auf die entsprechenden Gehäuseabschnitte bzw. -teile aufzuformen und unter relativ hoher Temperatur und/oder hohem Druck auszuhärten.

Dieses Verfahren ist bei druck- und/oder temperaturempfindlichen Teilen, wie etwa Leiterplatten oder metallisierten Kunststoffgehäusen, nicht anwendbar und infolge der geringen Reißfestigkeit der verwandten Materialien mit Problemen beim Entformen und damit einer relativ hohen Ausschußquote und - insbesondere bei komplizierten Gehäuse- bzw. Dichtungsformen - auch vielfach mit der Notwendigkeit zeit- und kostenaufwendiger Nacharbeit an den Abpreßkanten verbunden.

Sollen etwa die Kantenbereiche zweier gestapelter Leiterplatten mit einer Abschirmung versehen werden, so daß der Raum zwischen den beiden Leiterplatten gegenüber dem Außenraum elektromagnetisch abgeschirmt und gleichzeitig abgedichtet ist, können je nach Abstand der Leiterplatten relativ hohe Abschirmprofile erforderlich werden, die - einstückig als flexible Dichtelemente gefertigt - mechanisch wenig stabil sind und keine dauerhaft sichere Abschirmung gewährleisten.

Der Erfindung liegt daher die Aufgabe zugrunde, ein insbesondere zur Abdichtung von wiederholt zu öffnenden und wieder zu verschließenden Abschirmgehäusen sowie zur Abschirmung des Raumes zwischen Leiterplatten geeignetes Abschirmelement, dessen Aufbau eine leichtere, automatisierbare Handhabung ermöglicht und das materialökonomisch herstellbar ist, sowie ein Verfahren zu dessen Herstellung anzugeben. Insbesondere auch bei einfach und preiswert in größeren Stückzahlen herzustellenden Gehäusen und Leiterplattenabschirmungen sollen dieses Abschirmelement und das Verfahren einsetzbar sein.

Diese Aufgabe wird durch ein Abschirmelement mit den Merkmalen des Anspruchs 1 bzw. ein Verfahren mit den Merkmalen des Anspruchs 9 gelöst.

Die Erfindung schließt den Gedanken ein, das Abschirmelement aus einem starren, vorgefertigten Teil und einem unmittelbar auf dessen Oberfläche aufgetragenen - insbesondere aufdispenserten - elastischen, leitfähigen Abdichtprofil zu bilden. Dieses wird durch Aufbringen einer die erwünschten Eigenschaften aufweisenden, sich auf der Oberfläche schnell verfestigenden, pastösen oder flüssigen Masse, die aus einer über dem starren Teil entlanggeführten Öffnung austritt, erzeugt. Die Masse ist eine Kunststoffmasse, welche leitende Einschlüsse - insbesondere in Form von Metallpartikeln oder Kohlenstoffteilchen - enthält. Ein derartiges Abschirmelement läßt sich wesentlich günstiger handhaben als ein die bekannten vollständig aus elastischem Material bestehenden Dichtungsringe, welche wegen ihres geringen Querschnitts bereits schwer zu entformen waren und dabei leicht zerissen. Im übrigen war - wegen der üblicherweise kleinen Abmessungen - der Abfall im Bereich der Spritzkanäle stets größer als der auf das Werkstück entfallende Materialanteil.

Das vorgefertigte starre Teil kann insbesondere Leisten- oder Rahmenform haben und auf herkömmliche Weise mittels Extrusion oder Spritzgießen beispielsweise aus einem lufthärtenden Thermoplastwerkstoff hergestellt werden. Es kann insbesondere aus einem Kunststoff mit leitfähigen Beimengungen, wie sie auch die elastische Masse enthält, oder auch mit einer Oberflächenmetallisierung bestehen. Bei geeigneter (etwa die Kantenbereiche des starren Teils umgreifender) Aufbringung der leitfähigen Dichtmasse kann das starre Teil auch aus nichtleitendem Material gefertigt werden. Entsprechend kann auch eine in ein Gehäuse oder zwischen zwei Leiterplatten einzufügende zwischenwandung auf ihren Stirnkanten mit einem Ring aus elastischem leitenden Material gemäß der Erfindung versehen sein, so daß diese eingefügte Wandung eine Abschirmfläche bildet, welche durch den entsprechenden Anschluß an leitende Nachbarflächen ebenfalls Teil eines faradayschen Käfigs sein kann.

Je nach Anwendungsfall wird das Aufbringen einer elastischen Dichtung nur auf eine Fläche oder auf mehrere - in der Regel insbesondere auf zwei einander gegenüberliegende - Oberflächen des starren Teils erfolgen.

Durch den genannten Aufbau wird ein Abschirmelement mit breitem Anwendungsbereich geschaffen, mit dem einerseits die erwähnten Handhabungsprobleme vermieden werden und andererseits eine gute Materialausnutzung und -wiederverwertbarkeit erreicht wird.

Wenn dabei die zur Bildung des Profils verwendete Hohlnadel bzw. Düse maschinell, insbesondere rechnergesteuert, über den Abschnitt des starren Teils, an dem das Abschirmprofil angeordnet sein soll, geführt wird, ist eine hohe Präzision und große Flexibilität bei der Formgebung des Profils gewährleistet, so daß auch kompliziert geformte Abschirmelemente in kleinen Serien wirtschaftlich hergestellt werden können.

Die Erzeugung besonderer Querschnittsformen des Abschirmelements - etwa auch mit Hinterschneidungen, Aussparungen etc. - erfolgt günstigerweise über die Vorfertigung einer entsprechend geformten im wesentlichen starren Leiste bzw. eines entsprechenden Rahmenteils, beispielsweise durch als Spritzteil oder durch Formpressen.

Unabhängig davon ist aber auch die Bildung komplizierter Formen der elastischen Dichtung selbst dadurch möglich, daß zur Herstellung eines mehrschichtigen Abschirmprofils eine Nadel bzw. Düse mehrfach mindestens über vorbestimmte Bereiche des Abschnitts, an dem das elastische Abschirmprofil angeordnet sein soll, geführt und dabei jeweils ein genau vorbestimmter Profilabschnitt gebildet wird. Dadurch kann in vorteilhafter Weise ein vorbestimmtes Querschnittsprofil in mehreren Arbeitsgängen nacheinander erzeugt werden, wobei entweder ein und dieselbe Düse die betreffende Stelle mehrfach überstreicht oder aber mehrere Düsen unterschiedliche Stränge nacheinander auftragen, die sich zu der gewünschten Dichtungsform ergänzen.

Vorzugsweise lassen sich auf diese Weise auch Profilquerschnitte erzeugen, welche vorbestimmte Elastizitätseigenschaften aufweisen und diese Elastizität nicht aufgrund ihrer Kompressibilität, sondern aufgrund einer Biegeverformung erhalten, wie das bei gebogenen Lippenprofilen oder Hohlprofilen der Fall ist.

Insbesondere ist es auch nicht nötig, jeden Strang des Materials mit leitendenden Einschlüssen zu versehen, da auf Grund der Gesetze des elektromagnetischen Feldes auch annähernd linienförmige Leiter bereits eine große Abschirmwirkung erzielen.

Mit den genannten Maßnahmen lassen sich auch kompliziert geformte Abdichtungsprofile auf dem starren Teil mit entlang ihrem Verlauf variierenden Abmessungen ohne besondere Schwierigkeiten erzeugen. Dabei kann sich der Querschnitt entlang der zu dichtenden Kante in weiten Grenzen entsprechend den jeweiligen Anforderungen verändern. Es lassen sich auch solche Formen von Abschirmprofilen erzeugen, welche derart zusammenhängen, daß sie in dieser Form einstückig nicht hätten erzeugt und montiert werden können. Damit können Trennfugen im Verlauf der abschirmenden Dichtung entfallen, so daß die Dicht- und Abschirmwirkung an keiner Stelle verlorengeht.

Dadurch, daß beim mehrfachen Führen der Nadel bzw. Düse über die vorbestimmten Bereiche unterschiedliche elastische Materialien aufgebracht werden, wobei bei mindestens einem Auftrag leitfähiges Material aufgebracht wird, lassen sich Abschirmungen mit vorteilhaft optimierten Leitfähigkeits-, Korrosions- und elastischen Eigenschaften der Dichtungen herstellen.

Zum Aufbringen der elastischen Abschirmprofile lassen sich computergesteuerte Handhabungsgeräte verwenden, die eine dreidimensionale Führung der Nadel oder Düse zulassen, wobei ein vierte Größe die Dosierung des noch flüssigen oder pastösen Materials in Abhängigkeit vom Vorschub darstellt. Als fünfte Steuergröße kann die Materialauswahl dienen, d.h. es lassen sich verschiedene Materialstränge abwechselnd oder in einem Arbeitsgang gleichzeitig aufbringen, so daß Materialeigenschaften des gesamten Profils im Querschnitt oder Längs-Verlauf ortsabhängig variieren. Diese Eigenschaften können die Leitfähigkeit, die Elastizität (Biegsamkeit bzw. Kompressibilität) und/oder die Aushärtungs- oder Klebeeigenschaften des Materials sein. Auf diese Weise kann mittels der abschirmenden Dichtungselemente auch ein dichtes Verschließen des durch das Abschirmelement abzuschirmenden Raumes durch Verkleben erfolgen, wenn benachbarte Materialstränge die entsprechenden Eigenschaften aufweisen.

Weitere vorteilhafte Weiterbildungen der Erfindung sind in den Unteransprüchen gekennzeichnet bzw. werden nachstehend zusammen mit der Beschreibung der bevorzugten Ausführungen der Erfindung anhand der Figuren näher dargestellt. Es zeigen:
Fig. 1 eine Prinzipskizze einer Ausführungsform des erfindungsgemäßen Abschirmelements wärend seiner Herstellung und in Bezug auf seine Verwendung,
Fign. 2a bis i schematische Teil-Querschnittsdarstellungen von Abschirmungsprofilen, die Bestandteil von Ausführungsformen des erfindungsgemäßen Abschirmelementes sind und in Ausführungsformen des erfindungsgemäßen Verfahrens hergestellt werden können,
Fig. 3 eine schematische Darstellung des Verlaufs einer starren Leiste mit Abschirmungsprofil gemäß einer Ausführungsform der Erfindung,
Fig. 4a und 4b schematische Querschnittsdarstellungen zweier weiterer Ausführungsformen der Erfindung und
Fig. 5 eine Querschnittsdarstellung eines Kantenbereiches zweier Trägerplatten für elektronische Bauelemente mit einem Abschirmrahmen nach einer weiteren Ausführungsform der Erfindung,

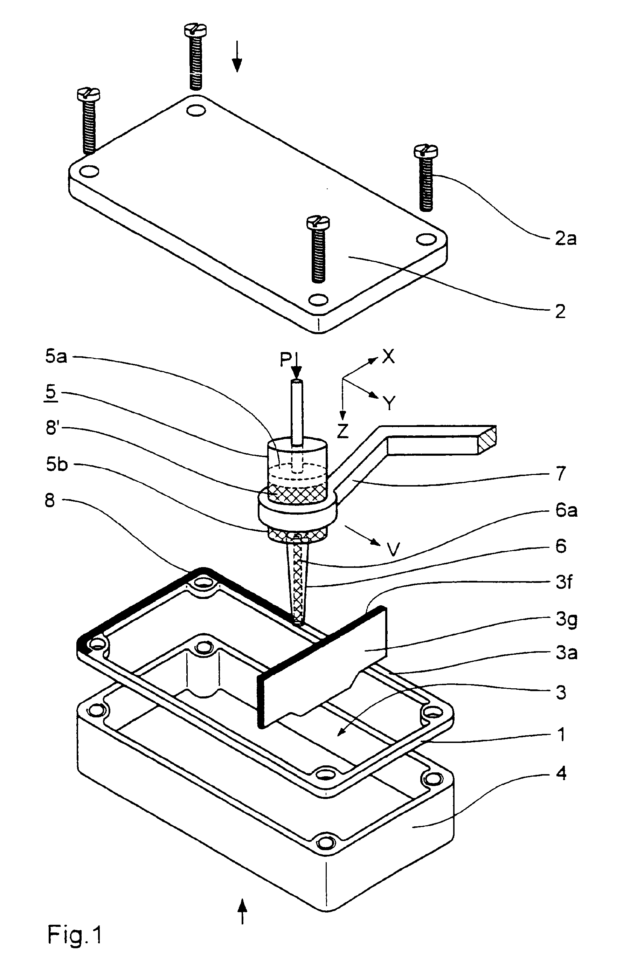

In Fig. 1 ist ein Abschirmrahmen 1 gezeigt, der den Zwischenraum zwischen zwei übereinander zu stapelnden, bestückten Gehäuseteilen 2 und 4 und damit die dort angeordneten Bauelemente und Verbindungen abschirmt. Die Grundform des Abschirmrahmens ist durch ein spritzgegossenes Kunststoffteil 3 mit Bohrungen, die dem Verschrauben der Leiterplatten 2 und 4 mit dem Rahmen 1 dienen, vorgegeben. Anstelle von Gehäuseteilen kann der Rahmen 1 auch als zwischenlage von benachbarten Leiterplatten dienen, dessen geerdete, die elastischen Bereiche des Rahmens kontaktierenden Kanten ebenfalls einen abgeschirmten Raum umschließen können.

Weiter ist in Fig. 1 ersichtlich, wie an den Kanten des starren Kunststoffteils 3 über eine luftdicht mit einer Kolben-Zylinder-Vorrichtung 5 verbundene Auftragnadel 6, die zusammen mit der Kolben-Zylinder-Vorrichtung 5 durch einen rechnergesteuerten Roboterarm 7 unter Ausübung von Druck p auf den Kolben 5a der Vorrichtung 5 mit geringem und sehr genau eingehaltenem Abstand zum Teil 3 mit der Geschwindigkeit v längs der umlaufenden Kante 3a geführt wird, eine elastische, leitfähige aus einem oder mehreren Strängen bestehende Dichtungsschicht 8 aufgebracht wird. Der Roboterarm 7 ist durch einen entsprechenden Antrieb in den drei Raumrichtungen x, y und z führbar.

In den unteren Teil 4 des Gehäuses ist vor dessen Verschließen mittels Schrauben 2a eine zwischenwandung 3g einfügbar, deren Stirnkanten ebenfalls mit einem elastisch aushärtenden Strang 3f versehen sind, so daß dies Zwischenwandung einen getrennt abgeschirmten Bereich innerhalb des Gehäuses umschließt.

Der Zylinder 5b der Vorrichtung 5 ist mit einem schnell luft- und raumtemperaturtrocknenden, Umgebungstemperatur aufweisenden pastösen Silikonpolymeren 8' mit eingelagerten Metallpartikeln gefüllt, die unter dem auf den Kolben 5a ausgeübten Druck durch die Kanüle 6a der Hohlnadel oder Düse 6 auf die Gehäuseoberfläche aufgebracht ("dispensiert") wird, dort anhaftet und unter Luftzutritt zur elastischen Dichtungsschicht 8 aushärtet.

Der erzeugte Strang entspricht in seinem Außenquerschnitt dem Innenquerschnitt der Düse oder Hohlnadel und härtet in der Umgebungsluft bei Raumtemperatur zu einem elastischen Strang aus, wobei ein vor dem Vernetzen der Oberfläche aufgebrachter zweiter Strang sich mit dem ersten materialeinheitlich verbindet.

Die (Querschnitts-)Abmessungen und Gestalt der Dichtungsschicht 8 werden zusätzlich durch die physikochemischen Eigenschaften der verwendeten leitfähigen Kunststoffmasse - insbesondere deren Aushärtungsgeschwindigkeit, Viskosität, Oberflächenspannung bezüglich des Gehäusematerials und Thixotropie -, durch den Querschnitt der Kanüle, den auf den Kolben ausgeübten Druck, die Geschwindigkeit der Nadelbewegung sowie durch Umgebungseinflüsse wie Temperatur und Luftfeuchtigkeit am Herstellungsort bestimmt und sind daher durch geeignete Wahl dieser Parameter vorgebbar.

Beim in Fig. 1 gezeigten Abschirmrahmen 1 wird die Hohlnadel 6 längs einem geradlinigen Kantenabschnitt des starren Teils 3 mit höherer Geschwindigkeit als in den Eckabschnitten geführt, um eine optimale Gestalt des Strangs zu erhalten. Die Einstellung der Eigenschaften der Kunststoffmasse kann dabei insbesondere durch Hinzufügung von Füllstoffen (Ruß o.ä.), Metallbindemitteln, Tensiden und Aushärtungsbeschleunigern bzw. Vernetzungswirkstoffen erfolgen.

Auch die Art und Korngröße der die Leitfähigkeit sichernden Beimengung - etwa Kohlenstoff-, Silber, mit Silber oder Gold ummantelte Kupferpartikeln o.ä. - beeinflußt nicht nur die elektrischen, sondern auch die mechanischen und Verarbeitungseigenschaften des leitfähigen elastischen Materials.

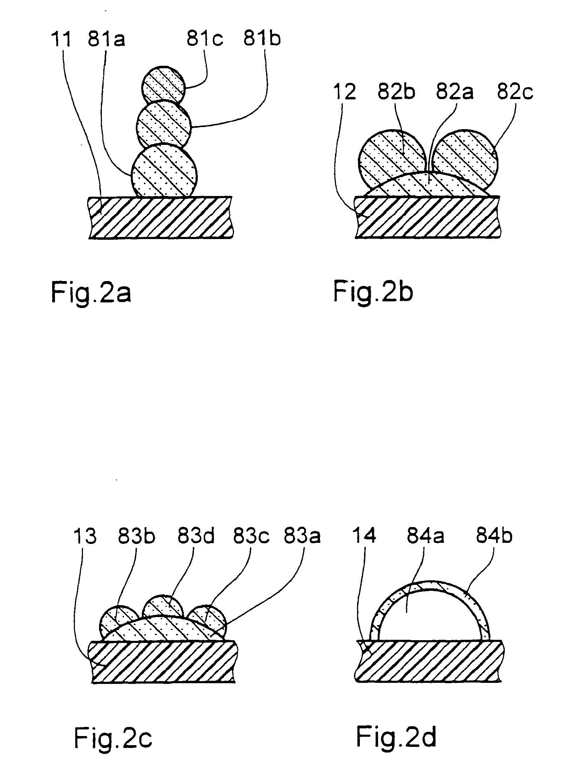

In den Fign. 2a bis i sind Beispiele unterschiedlicher Anordnungen für profilierte elastische Dichtungsschichten im Querschnitt gezeigt, die mittels des erfindungsgemäßen Verfahrens bei Vorsehen mehrerer Auftrags-Schritte für die Dichtungsmasse hergestellte Abschirmelemente aufweisen können. Es ist aber ersichtlich, daß mit den erfindungsgemäßen Maßnahmen die elastischen Profile in den geometrischen Abmessungen und Materialeigenschaften auch in Längsrichtung variieren können.

In den Fign. 2a bis 2d sind dabei leitende, weniger elastische Dichtungsteile (schraffiert dargestellt) mit nichtleitenden, aufgrund der fehlenden Metallbeimengung elastischeren Dichtungsteilen kombiniert, wodurch eine optimale Verbindung von Dicht- und Abschirmwirkung erreicht wird.

Fig. 2a zeigt insbesondere einen aus in zwei Auftragsschritten nebeneinander auf der Oberfläche eines Abschirmelements 11 aufgebrachten Profilen 81a und 81b mit annähernd kreisförmigem Querschnitt gebildeten Abschirmungs- und Dichtungsaufbau. Ein solcher Aufbau ergibt sich, wenn das elastische Material die Oberfläche des starren Teils schwach benetzt.

Fig. 2b zeigt einen in drei Schritten erzeugten Profilaufbau aus einem flach gewölbten, breiten leitfähigen Profilteil 82a und einem auf dieses auf"dispensierten" leitfähigen Teil 82c und einem nicht leitfähigen Teil 82b auf einem starren Teil 12, wobei die Teile 82b und 82c annähernd kreisförmigen Querschnitt haben.

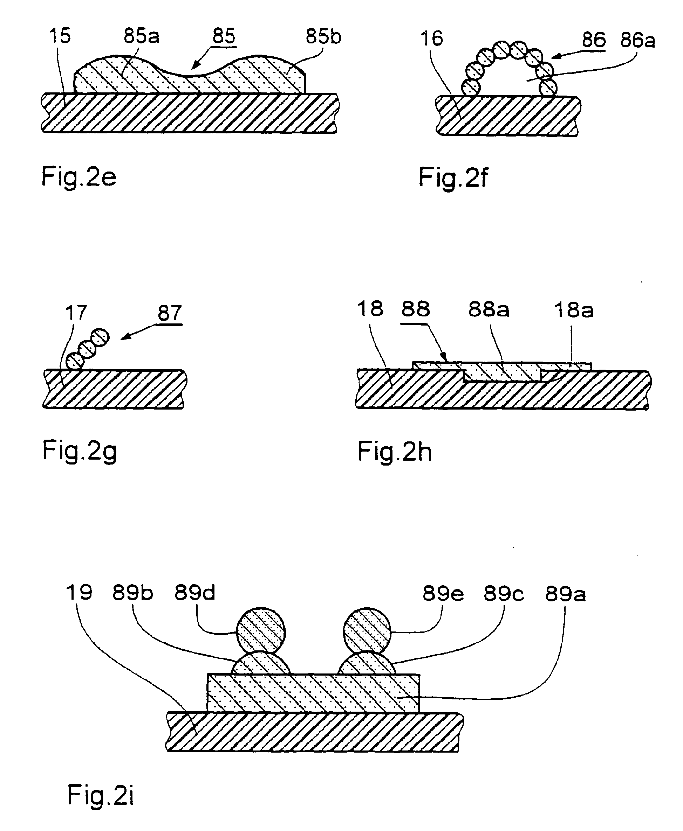

Ein solcher Aufbau ergibt sich, wenn das Material de ersten Profilteils 82a die Oberfläche des starren Teils stark benetzt und/oder dessen Auftrag mit einer relativ breiten Düse anstelle der in Fig. 2 gezeigten Nadel 6 erfolgte, während das Material der Teile 82b und 82c geringe Benetzungsneigung gegenüber der Oberfläche des Teils 82a zeigt.

Fig. 2c zeigt einen zu Fig. 2b ähnlichen Aufbau, wobei allerdings beidseitig eines auf einem unteren, breiten Profilteil 83a auf einer Gehäuseoberfläche 13 zentral angeordneten hochelastischen, aber nicht leitfähigen, knapp halbkreisförmigen Dichtprofils 83d zwei ebenfalls annähernd halbkreisförmige, leitfähige Abschirm-Profilteile 83b und 83c angeordnet wurden.

Dieses letzere Profil zeigt große Stabilität gegenüber parallel zur Gehäuseoberfläche wirkenden Kräften, hat jedoch insgesamt eine vergleichsweise geringe Elastizität. Damit kann es etwa für Schiebeverschlüsse besonders geeignet sein.

Das Profil nach Fig. 2d, das aus einem halbkreisförmig auf eine Gehäuseoberfläche 14 aufgedrückten elastischen, nichtleitenden Profilteil 84a und einem dessen Oberfläche ummantelnden leitfähigen Überzug 84b besteht, weist hingegen ausgeprägt gute Elastizitätseigenschaften auf.

Seine Herstellung setzt hohes Benetzungsvermögen und gute Haftfähigkeit zwischen den Oberflächen der beiden Profilmaterialien voraus, und es eignet sich sehr gut für Klappverschlüsse, insbesondere, wenn Verschluß- und Gehäuseteile relativ viel Spiel gegeneinander haben oder selbst gewisse Elastizität aufweisen.

Die Fign. 2e bis 2i zeigen Dichtungs- und Abschirmprofile, die ausschließlich aus leitfähigem Material bestehen.

Fig. 2e zeigt dabei ein einteiliges Profil 85 auf einem starren Grundkörper 15, das zwei durch eine flachen Steg vebundene Wülste 85a und 85b aufweist. Ein solches Profil kann für Abschirmungen bzw. Gehäuse mit kantenprofilierten Klappverschlüssen zweckmäßig sein.

Fig. 2f zeigt ein aus mehreren kreisförmigen Profilsträngen insgesamt halbkreisförmig aufgebautes Abschirmprofil 86 auf einer Oberfläche 16, das mit dieser einen Luftraum 86a einschließt.

Das Zusammenwirken des Profils mit dieser "Luftkammer" sorgt für gute Elastizität des Gesamtprofils trotz vergleichsweise schlechter Elastizität seiner Bestandteile.

In Fig. 2h ist ein T-förmiges Profil 88 auf einer eine rechteckige Nut 18a aufweisenden Oberfläche eines starren Teils 18 dargestellt, das mit einem breiten Mittelteil 88a in die Nut 18a eingreift und insgesamt eine ebene Oberfläche aufweist.

Dieses Abschirmprofil ist mit dem starren Grundteil nicht nur stoff-, sondern auch formschlüssig verbunden, was seine Stabilität zusätzlich erhöht.

In Fig. 2i ist ein Profilaufbau aus einem annähernd rechteckigen Querschnitt aufweisenden Block 89a aus leitfähigem, elastischem Material auf einem flachen, breiten Grundteil 19 und zwei darauf nebeneinander angeordneten, flach gewölbten Profilteilen 89b und 89c gezeigt, der durch seinen großen Querschnitt insbesondere zur Abschirmung gegenüber starken Feldern geeignet ist. aber durch die aufgesetzten Dichtlippen 89b und 89c auch ausreichende Elastizität aufweist. Je nach Anwendungsfall sind auch beliebige andere Querschnitte und Raumformen durch zeitlich sequentiell aufgetragene Stränge aus elastisch vernetzendem Kunststoffmaterial realisierbar.

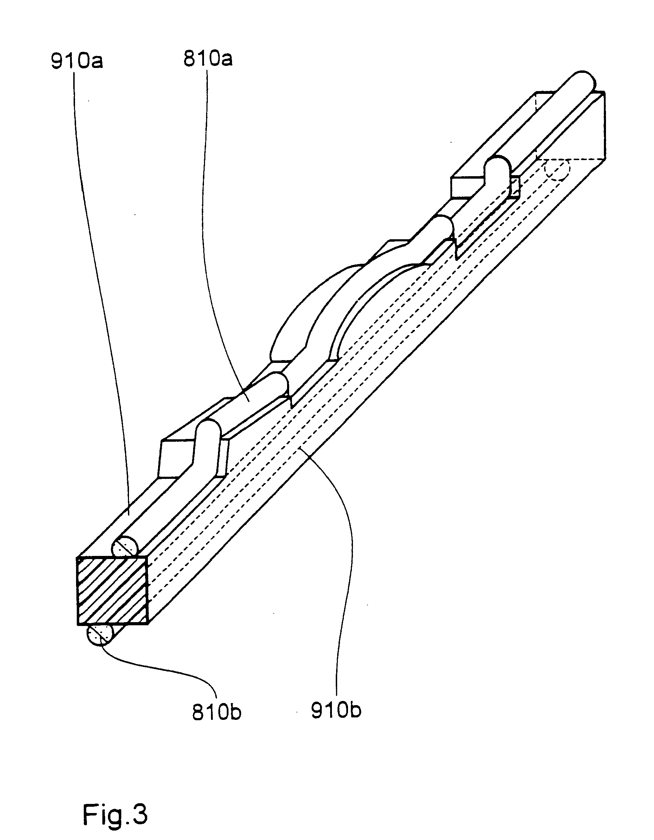

In Fig. 3 ist in perspektivischer Darstellung ein langgestrecktes Abschirmelement (Abschirmleiste) 910 mit drei glatten und einer stark strukturierten Längsseitenfläche 910a gezeigt, das auf dieser und der ihr gegenüberliegenden Fläche je ein in Längsrichtung verlaufendes Dichtprofil 810a bzw. 810b aufweist. Das Dichtprofil 810a auf der Oberfläche 910a paßt sich deren Relief aufgrund seiner Aufbringung mittels einer koordinatengesteuerten Dispenser-Vorrichtung optimal an.

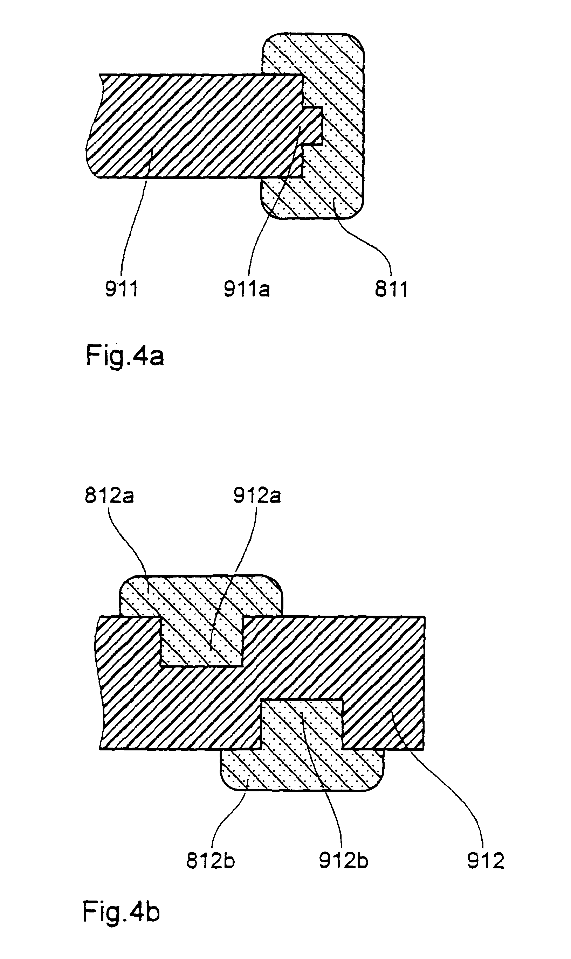

Fig. 4a und 4b zeigen jeweils eine schematische Querschnittsdarstellung eines Abschirmelementes in einer weiteren Ausführungsform der Erfindung.

In Fig. 4a ist ein aus nichtleitendem Kunststoff bestehendes Grundteil 911 gezeigt, dessen mit einer Feder 911a versehener Kantenbereich mit einem U-förmigen Abdichtprofil 811 aus leitfähigem. elastischem Thermoplastwerkstoff umgeben ist. Bei diesem Abschirmelement wird ie Abschirm- und Dichtwirkung ausschließlich von dem U-förmigen Abdichtprofil 811 erbracht, während das Teil 911 lediglich als dessen Träger und mechanische Verstärkung dient.

In Fig. 4b ist der Kantenbereich eines Grundteils 912 aus leitfähigem Kunststoff gezeigt, in dessen einander gegenüberliegende Oberflächen je eine Nut 912a bzw. 912b eingearbeitet ist, in die jeweils ein elastisches Dichtprofil 812a bzw. 812b eingebracht ist, das sich über die Kanten der Nut hinaus auf einen Bereich der Oberfläche des Teils 912 erstreckt. Bei diesem Abschirmelement wird die Abschirmwirkung von Grundteil und elastischem Dichtprofil gemeinsam erbracht.

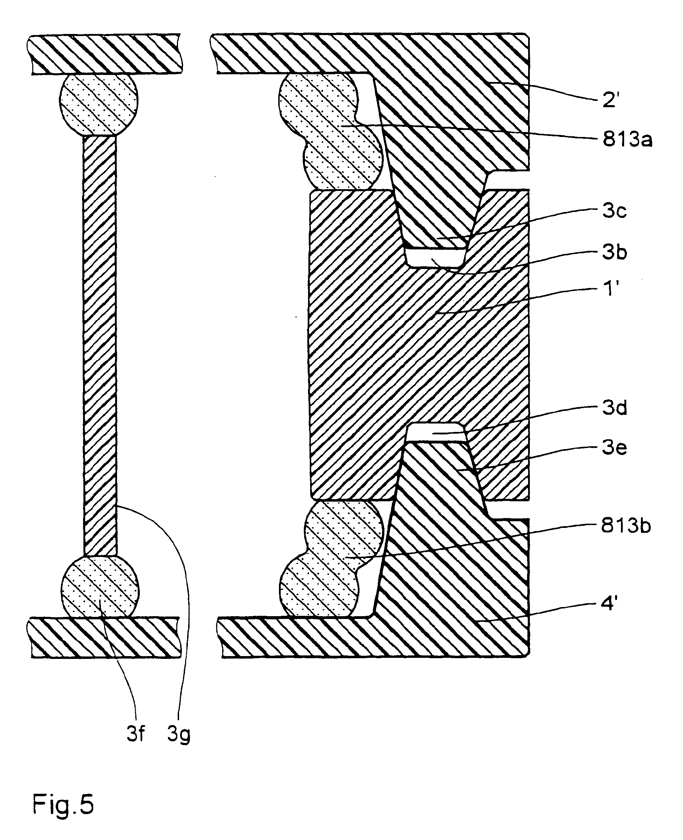

In Fig. 5 ist in einer Detaildarstellung ein Ausführungsbeispiel eines mit einem erfindungsgemäßen Abschirmelement versehenen Gehäuses im Bereich einer Stoßkante wiedergegeben. Das Gehäuse besteht aus einem Oberteil 2', welches mit einer umlaufenden Feder 3c versehen ist, welche in eine entsprechende umlaufende Nut 3b eines Abschirmrahmens 1' eingreift, und einem Gehäuseunterteil 4'. Nut und Feder 3b bzw. 3c verjüngen sich, so daß ein relativ dichter Abschluß des Gehäuseoberteils mit dem Abschirmrahmen gewährleistet ist, wobei der gegenseitige Abstand der Teile 2' und 1' jedoch aufgrund von Fertigungstoleranzen variieren kann. Ein Dichtprofil 813a sorgt nun für eine zusätzliche Abdichtung und Abschirmung im Bereich der Kante, welche unabhängig von der relativen Position des Gehäuseoberteils 2' und des Abschirmrahmens 1' ist.Durch die Neigung der maximalen Querschnittserstreckung des Dichtprofils 813a in Bezug auf die Richtung der Zusammenfügung der beiden Gehäuseteile wird die Elastizität sowohl durch die Kompressibilität als auch durch die Biegeverformbarkeit des Profils unterstützt.

Im Schnitt dargestellt ist weiterhin eine eingefügte Zwischenwandung 3g, die sich mittels eines mit dem erfindungsgemäßen Verfahren erzeugten Dichtprofils 3f an der Gehäusewandung abstützt und damit eine Abschirmung bildet.

Analog zum beschriebenen Aufbau am Gehäuseoberteil 2' ist der Aufbau am Gehäuseunterteil 4', wo eine Nut 3d und eine mit dieser zusammenwirkende Feder 3e sowie eine elastische, leitfähige Dichtung 813b vorgesehen sind.

Auf die beschriebene Weise werden geringfügige Inhomogenitäten der Dichtigkeit der Abschirmung aufgrund der Gehäusepassungen sicher überbrückt und es läßt sich eine insgesamt hervorragende elektromagnetische Verträglichkeit erzielen.

Wenn in der vorangegangegen Beschreibung von Abschirmelementen und starren Teilen o.ä. gesprochen wurde, so werden unter diesen Begriffen auch Teile gefaßt, die auch mechanische Träger- bzw. Gehäuseteil-Funktionen haben können.

Die Erfindung beschränkt sich auch darüber hinaus in ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch macht.

## Patentansprüche

1. Anordnung von zwei gestapelten Leiterplatten mit einem als Zwischenlage dienenden Abschirmelement zur Vergrößerung der elektromagnetischen Verträglichkeit von elektrischen, insbesondere elektronischen, Funktionsgruppen, in welchen die Leiterplatten (2, 4, 2', 4') enthalten sind, wobei die Leiterplatten elektrisch leitende abschirmende Bereiche aufweisen, wobei das Abschirmelement in Form eines Abschirmrahmens oder einer Abschirmleiste ein Zwischenelement zur dichtenden leitenden Überbrückung derartiger abschirmender Bereiche bildet, wobei die Längserstreckung des Zwischenelements groß ist zu den Abmessungen seines, insbesondere nach Art einer Profildichtung gestalteten Querschnitts, wobei das Abschirmelement ein im wesentlichen starres Trägerelement (1, 1', 11-19, 910-912) umfasst, welches mindestens eine aus elektrisch leitfähigem Material unmittelbar auf einer seiner längsgerichteten Deckflächen aufgebrachte kompressible oder elastische Schicht (8, 8', 81-89, 810a-813b) bzw. einen entsprechenden Strang aufweist, wobei das elektrisch leitfähige Material ein luft- und raumtemperaturtrocknendes Silikonpolymer ist und wobei mindestens eine elastische bzw. kompressible Schicht bzw. ein kompressibler Strang (81 bis 89) mindestens bereichsweise aus jeweils mehreren Teilschichten bzw.-Teilsträngen (81a bis 89c) aufgebaut ist.

2. Anordnung nach Anspruch 1 , **dadurch gekennzeichnet, daß** die kompressible bzw. elastische Schicht (8; 8'; 81 bis 89; 810a bis 813b) die Oberfläche des im wesentlichen starren Trägerelements (1; 1'; 11 bis 19; 910 bis 912) in strangartig ausgeformter Erstreckung, bedeckt.

3. Anordnung nach Anspruch 2 , **dadurch gekennzeichnet,daß** je eine elastische bzw. kompressible Schicht bzw. Strang auf einander gegenüberliegenden Deckflächen des Trägerelements (1; 1'; 11 bis 19; 910 bis 912) gebildet ist, wobei diese Schichten bzw. Stränge in elektrisch leitender Verbindung miteinander stehen.

4. Anordnung nach einem der vorangehenden Ansprüche, **dadurch gekennzeichnet, daß** das Trägerelement (1; 1'; 11 bis 19; 119, 910 bis 912) aus metallisiertem oder mit einer leitfähigen Beimengung versehenem Kunststoff und/oder aus nichtleitendem Material besteht und in einem Kantenbereich des Trägerelements eine diesen zusammenhängend umgreifende und die einander gegenüberliegenden Flächen jeweils mindestens teilweise bedeckende Schicht (811) gebildet ist und/oder die einander gegenüberliegenden Flächen verbindende Durchbrüche aufweist, in die hinein sich die Schicht aus leitendem elastischem Material erstreckt und die sie ausfüllt.

5. Anordnung nach einem der vorangehenden Ansprüche, **dadurch gekennzeichnet, daß** jede Teil-Schicht auf der darunterliegenden und mit dieser fest haftend verbunden gebildet ist.

6. Anordnung nach einem der vorangehenden Ansprüche, **dadurch gekennzeichnet, daß** die mehrteilige Schicht (81 bis 84) eine Teil-Schicht bzw. Teil-Strang aus stark elastischem, aber nicht oder wenig leitfähigem Material (81a, 82b, 83d, 84a) und eine Trägerschicht bzw. einen Trägerstrang aus wenig elastischem, aber stark leitfähigem Material (81b, 82a, 82c, 83a bis c, 84b) umfaßt.

7. Anordnung nach einem der vorangehenden Ansprüche, **dadurch gekennzeichnet, daß** der Querschnitt des Strangs mindestens einer der Schichten einen lippenförmigen Ansatz aufweist.

8. Anordnung nach einem der vorangehenden Ansprüche, **dadurch gekennzeichnet, daß** mindestens eine der Schichten (86) oder Stränge derart aus mehreren Teil-Schichten oder Teil-Strängen aufgebaut ist, daß sie ein Hohlprofil bilden.

9. Verfahren zur Herstellung einer Anordnung nach einem der vorangehenden Ansprüche, wobei das elektrisch leitfähige Material mittels Druck aus einer Hohlnadel (6) bzw. Düse als Schicht oder Strang in pastöser Form direkt auf Abschnitte (3a) des starren Trägerelements (1) durch Dispensieren aufgebracht und nach dem Aufbringen unter Anhaften und Beibehaltung der Querschnittsform zu einem entsprechenden elastischen Körper gehärtet bzw. vernetzt wird.

10. Verfahren nach Anspruch 9, **dadurch gekennzeichnet, daß** die Hohlnadel (6) bzw. Düse durch Antriebsmittel, insbesondere rechnergesteuert, auf einem vorgegebenen Weg über den Bereich (3a) des Teils (1), an dem der Formkörper (8) erzeugt werden soll, geführt wird.

11. Verfahren nach Anspruch 9 oder 10, **dadurch gekennzeichnet, daß** zur Herstellung eines Abschirmelements mit einer aus mehreren Teil-Schichten bestehenden Schicht (81 bis 89) die Hohlnadel (6) bzw. Düse mehrfach mindestens über vorbestimmte Bereiche des Abschnitts, an dem die mehrteilige Schicht oder der mehrteilige Strang angeordnet sein soll, derart geführt wird, daß sich aus mehreren Schichten bzw. Strängen des elastichen leitfähigen Materials ein vorgegebener Formkörper vorgegebener Gestalt aufbaut, wobei eine nachfolgende Schicht oder ein nachfolgender Strang vor dem Aushärten bzw. Vernetzen der Oberfläche des vorangehenden Strangs aufgebracht wird, so daß beide Schichten bzw. Stränge sich nach dem Aushärten oder Vernetzen materialkonform verbinden.

12. Verfahren nach einem der Ansprüche 9 bis 11, **dadurch gekennzeichnet, daß** das Aufbringen des elastischen leitfähigen Materials bei Raumtemperatur erfolgt.

## Claims

1. Arrangement of two stacked conductive plates having a shielding member, serving as an intermediate layer, for enhancing the electromagnetic compatibility of electrical, especially electronic, function groups, which contain the conductive plates (2, 4, 2', 4'), the conductive plates having electrically-conductive shielding areas, the shielding member in the form of a shielding frame or a shielding strip forming an intermediate element for sealingly and conductively bridging said shielding areas, the longitudinal extent of the intermediate element being large compared to the dimensions of its cross-section, which in particular is shaped in the form of a profile seal, wherein the shielding member comprises a substantially rigid carrier element (1, 1', 11 to 19, 910 to 912), which has at least one compressible or resilient layer (8, 8', 81-89, 810a-813b) or a corresponding strip, of electrically-conductive material applied directly to one of its outer longitudinal surfaces, the electrically-conductive material being a silicon polymer that dries at air and room temperature and wherein at least one resilient or compressible layer or a compressible strip (81 to 89) is made up, at least in part, of a plurality of part-layers or part-strips (81a to 89c).

2. Arrangement according to claim 1, **characterised in that** the compressible, or resilient, layer (8, 8', 81 to 89; 810a to 813b) covers the surface of the substantially rigid carrier element (1; 1'; 11 to 19; 910 to 912) in a strip-like configuration.

3. Arrangement according to claim 2, **characterised in that** a respective resilient, or compressible, layer or strip is formed on opposing surfaces of the carrier element (1; 1'; 11 to 19; 910 to 912), these layers or strips being connected to each other in an electrically-conductive manner.

4. Arrangement according to one of the preceding claims, **characterised in that** the carrier element (1; 1'; 11 to 19; 119, 910 to 912) consists of a metallised plastic or a plastic combined with a conductive component, and/or of a non-conductive material, and that in an edge region of the carrier element a layer (811) is formed which engages connectingly around the carrier element and at least partially covers the opposing surfaces and/or contains openings which connect the opposing surfaces, the layer of conductive resilient material extending into and filling them.

5. Arrangement according to one of the preceding claims, **characterised in that** each part-layer is formed on and firmly attached to the one below.

6. Arrangement according to one of the preceding claims, **characterised in that** the layer (81 to 84) made up of a plurality of parts includes a part-layer or part-strip of strongly resilient but low- or non-conductive material (81a, 82b, 83d, 84a) and also a carrier layer or carrier strip of material with low resilience but high conductivity (81b, 82a, 82c, 83a to c, 84b).

7. Arrangement according to one of the preceding claims, **characterised in that** the cross-section of the strip of at least one of the layers has a lip-shaped projection.

8. Arrangement according to one of the preceding claims, **characterised in that** at least one of the layers (86) or strips is made up of a plurality of part-layers or part-strips in such a way as to form a hollow profile.

9. A process for the manufacture of an arrangement according to one of the preceding claims, wherein the electrically-conductive material is applied directly as a layer or strip in paste form to sections (3a) of the rigid carrier element (1) by dispensing under pressure via a hollow needle (6) or a nozzle, and after application is hardened or crosslinked into a corresponding resilient body, with adhesion and whilst maintaining the shape of the cross-section.

10. A process according to claim 9, **characterised in that** the hollow needle (6) or nozzle is guided by driving means, particularly computer-controlled, along a given path, over the area (3a) of the part (1), on which the moulding (8) is to be produced.

11. A process according to claim 9 or 10, **characterised in that** in order to manufacture a shielding member with a layer (81 to 89) comprising a plurality of part-layers, the hollow needle (6) or nozzle is repeatedly guided at least over predetermined areas of the section on which the layer or strip, comprising a plurality of parts, is to be arranged, in such a way that a given moulding of a given shape is formed from a plurality of layers, or strips, of the resilient conductive material, a subsequent layer or strip being applied before hardening or crosslinking of the surface of the preceding strip, so that the two layers or strips connect in a material-conforming manner after hardening or crosslinking.

12. A process according to one of claims 9 to 11, **characterised in that** the resilient conductive material is applied at room temperature.

## Revendications

1. Agencement de deux cartes imprimées empilées avec un élément de blindage servant de couche intermédiaire pour augmenter la compatibilité électromagnétique de groupes fonctionnels électriques, en particulier électroniques, dans lesquels sont contenues les cartes imprimées (2, 4 ; 2', 4'), lesdites cartes imprimées présentant des régions électriquement conductrices assurant un blindage, dans lequel l'élément de blindage, sous la forme d'un cadre ou d'une barrette de blindage forme un élément intermédiaire pour le pontage conducteur et étanche de telles régions de blindage, l'extension longitudinale de l'élément intermédiaire étant élevée par rapport aux dimensions de sa section transversale, réalisée en particulier à la manière d'un joint profilé, l'élément de blindage comportant un élément de support sensiblement rigide (1 ; 1' ; 11 à 19 ; 910 à 912) qui présente au moins une couche compressible ou élastique (8 ; 8' ; 81 à 89 ; 810a à 813b) en matière électriquement conductrice déposée sur l'une de ses surfaces de couverture dirigées longitudinalement, ou bien sur une bande correspondante, la matière électriquement conductrice étant un polymère aux silicones séchant à l'air et à la température ambiante, et dans lequel au moins une couche élastique ou compressible ou une bande compressible (81 à 89) est constituée au moins par secteur de plusieurs couches partielles ou bandes partielles respectives (81 a à 89c).

2. Agencement de blindage selon la revendication 1, **caractérisé en ce que** la couche compressible ou élastique (8 ; 8' ; 81 à 89 ; 810a à 813b) recouvre la surface de l'élément de support sensiblement rigide (1 ; 1' ; 11 à 19 ; 910 à 912) dans une extension formée à la manière de bande.

3. Agencement de blindage selon la revendication 2, **caractérisé en ce qu'**une couche ou bande élastique ou compressible respective est formée sur des surfaces de couverture en vis-à-vis l'une de l'autre de l'élément de support (1 ; 1' ; 11 à 19 ; 910 à 912), et ces couches ou bandes sont en liaison électriquement conductrice les unes avec les autres.

4. Agencement de blindage selon l'une quelconque des revendications précédentes, **caractérisé en ce que** l'élément de support (1 ; 1' ; 11 à 19, 910 à 912) est réalisé en une matière plastique métallisée ou pourvue d'un additif conducteur et/ou en un matériau non conducteur et **en ce que** dans une région d'arête de l'élément de support est formée une couche (811) entourant celui-ci avec cohérence et recouvrant du moins en partie les surfaces en vis-à-vis l'une de l'autre et/ou présentant des traversées reliant les surfaces en vis-à-vis l'une de l'autre, traversées dans lesquelles la couche en matériau conducteur élastique s'étend en les remplissant.

5. Agencement de blindage selon l'une quelconque des revendications précédentes, **caractérisé en ce que** chaque couche partielle est formée sur la couche située au-dessous et est reliée à celle-ci avec adhésion ferme.

6. Agencement de blindage selon l'une quelconque des revendications précédentes, **caractérisé en ce que** la couche en plusieurs parties (81 à 84) comporte une couche partielle ou une bande partielle en un matériau fortement élastique mais non conducteur ou peu conducteur (81a, 82b, 83d, 84a), et une couche de support ou une bande de support en un matériau peu élastique mais fortement conducteur (81b, 82a, 82c, 83a à c, 84b).

7. Agencement de blindage selon l'une quelconque des revendications précédentes, **caractérisé en ce que** la section transversale de la bande de l'une au moins des couches présente un talon en forme de lèvre.

8. Agencement de blindage selon l'une quelconque des revendications précédentes, **caractérisé en ce que** l'une au moins des couches (86) ou des bandes est conçue de telle sorte avec plusieurs couches partielles ou bandes partielles, qu'elles forment un profilé creux.

9. Procédé pour fabriquer un agencement de blindage selon l'une quelconque des revendications précédentes, dans lequel le matériau électriquement conducteur est déposé par distribution au moyen d'une pression hors d'une aiguille creuse (6) ou d'une buse, sous forme de couche ou de bande pâteuse directement sur des tronçons (3a) de l'élément de support rigide (1), et après déposition il est durci ou réticulé avec adhésion avec maintien de la forme de section transversale pour former un corps élastique correspondant.

10. Procédé selon la revendication 9, **caractérisé en ce que** l'aiguille creuse (6) ou la buse est guidée par des organes d'entraînement, en particulier à commande par ordinateur, sur un trajet prédéterminé au-dessus de la région (3a) de la pièce (1), dans laquelle le corps de formage (8) doit être réalisé.

11. Procédé selon l'une ou l'autre des revendications 9 et 10, **caractérisé en ce que** pour fabriquer un élément de blindage avec une couche (81 à 89) constituée par plusieurs couches partielles, l'aiguille creuse (6) ou la buse est guidée plusieurs fois au moins sur des régions prédéterminées du tronçon sur lequel la couche en plusieurs parties ou la bande en plusieurs parties doit être agencée, de telle sorte qu'un corps de formage prédéterminé présentant une forme prédéterminée se forme par plusieurs couches ou bandes du matériau élastique conducteur, et **en ce qu'**une couche successive ou une bande successive est déposée avant le durcissement ou la réticulation de la surface de la bande précédente, de sorte que les deux couches ou bandes se relient sur le plan matériel lors du durcissement ou de la réticulation.

12. Procédé selon l'une quelconque des revendications 9 à 11, **caractérisé en ce que** la déposition du matériau élastique conducteur s'effectue à température ambiante.
